# EUROPÄISCHE PATENTSCHRIFT

(11) **EP 1 080 500 B1**
(45) Veröffentlichungstag und Bekanntmachung des Hinweises auf die Patenterteilung: **27.11.2013**
(21) Anmeldenummer: 99934488.0
(22) Anmeldetag: 10.05.1999
(51) Int. Cl.: G01J 9/00, G01S 7/491

(54) **VORRICHTUNG UND VERFAHREN ZUR ERFASSUNG VON PHASE UND AMPLITUDE ELEKTROMAGNETISCHER WELLEN**
DEVICE AND METHOD FOR DETECTING THE PHASE AND AMPLITUDE OF ELECTROMAGNETIC WAVES
DISPOSITIF ET PROCEDE POUR LA DETECTION DE LA PHASE ET DE L'AMPLITUDE D'ONDES ELECTROMAGNETIQUES

(30) Priorität: 18.05.1998 DE 19821974
(43) Veröffentlichungstag der Anmeldung: 07.03.2001
(73) Patentinhaber: Schwarte, Rudolf, 57250 Netphen (DE)
(72) Erfinder: Schwarte, Rudolf, 57250 Netphen (DE)
(74) Vertreter: Weber, Roland
(86) Internationale Anmeldenummer: PCT/DE1999/001436
(87) Internationale Veröffentlichungsnummer: WO 1999/060629

(56) Entgegenhaltungen:
- DE-A- 19 704 496
- US-A- 4 826 312
- SPIRIG T ET AL: "THE LOCK-IN CCD - TWO-DIMENSIONAL SYNCHRONOUS DETECTION OF LIGHT" IEEE JOURNAL OF QUANTUM ELECTRONICS, Bd. 31, Nr. 9, 1. September 1995 (1995-09-01), Seiten 1705-1708, XP000526180 ISSN: 0018-9197

## Beschreibung

Die vorliegende Erfindung betrifft eine Vorrichtung zum Erfassen von Phase und Amplitude elektromagnetischer Wellen, und zwar vorzugsweise im optischen sowie im nahen Infrarot- und Ultraviolett-Bereich, mit mindestens zwei für die elektromagnetischen Wellen empfindlichen (bzw. lichtempfindlichen) Modulationsphotogates und mit diesen zugeordneten, nicht lichtempfindlichen bzw. abgeschatteten Akkumulationsgates, sowie mit elektrischen Anschlüssen für die Modulationsphotogates und die Akkumulationsgates, so daß letztere mit einer Ausleseeinrichtung und erstere mit einer Modulationseinrichtung verbindbar sind, wobei die Modulationseinrichtung das Potential der Modulationsphotogates relativ zueinander und auch relativ zu dem, vorzugsweise konstanten, Potential der Akkumulationsgates entsprechend einer gewünschten Modulationsfunktion anhebt oder absenkt.

Eine solche Vorrichtung ist unter dem Begriff "Photomischdetektor" (abgekürzt PMD) aus den deutschen Patentanmeldungen 196 35 932.5, 197 04 496.4 und der auf den beiden vorgenannten Anmeldungen beruhenden internationalen Patentanmeldung PCT/DE97/01956 bekannt geworden.

Die vorgenannten Anmeldungen gehen auf denselben Erfinder zurück und sind für den Anmelder der vorliegenden Anmeldung eingereicht worden, und es wird auf die gesamte Offenbarung dieser Voranmeldungen Bezug genommen, soweit darin die grundsätzliche Funktionsweise, der Betrieb und die Anwendungsmöglichkeiten von Photomischdetektoren beschrieben sind. Die vorliegende Anmeldung erläutert daher nicht diese grundlegenden Funktionen von Photomischdetektoren, sondern befaßt sich in erster Linie mit speziellen Ausgestaltungen und Anwendungen von Photomischdetektoren, durch welche die bereits bekannten Elemente optimiert werden.

Die bekannten PMDs sind aufgrund des inhärenten Mischprozesses, der beim Empfang des von einem Objekt ausgesandten oder reflektierten, modulierten Lichtes durch die mit der gleichen Modulationsfunktion modulierten Modulationsphotogates vorgenommen wird, in der Lage, unmittelbar die Laufzeit der von dem Objekt reflektierten elektromagnetischen Wellen zu erfassen und damit neben der lateralen Ortsauflösung, die mit Hilfe einer entsprechenden Optik wie bei herkömmlichen Kameras sichergestellt ist, gleichzeitig auch Abstandsinformationen über die aufgenommenen Bildelemente zu erhalten. Diese PMDs ermöglichen also eine direkte dreidimensionale Vermessung von Oberflächen, ohne daß aufwendige Auswertungen und Aufnahmen unter verschiedenen Winkeln erforderlich sind.

Um bei den bekannten PMDs eine hinreichende Empfindlichkeit und Tiefenauflösung zu erhalten, müssen die Pixelflächen genügend groß sein, damit während der Aufnahmedauer eines Einzelbildes von den verschiedenen Flächenbereichen des Objektes genügend elektromagnetische Strahlung empfangen wird und eine dementsprechende Anzahl von Ladungsträgern in dem photoempfindlichen Material entsteht, da letztlich über die unterschiedliche Zahl von Ladungsträgern, die zu unterschiedlichen Zeitpunkten an den Modulationsphotogates entstehen und über die unmittelbar angrenzenden Akkumulationsgates gesammelt werden, die Abstandsinformation gewonnen wird.

Dies bedingt eine gewisse Mindestgröße in der Fläche der einzelnen Pixel. Probleme können bei den herkömmlichen PMDs auch dadurch entstehen, daß sehr scharfe Hell-Dunkel-Grenzen des Objektes abgebildet werden. Wenn eine solche Hell-Dunkel-Grenze zufällig auf den Grenzbereich zwischen benachbarten Modulationsphotogates fällt, so täuscht die unterschiedliche Anzahl von Ladungsträgern an den benachbarten Akkumulationsgates und damit ein Korrelationsergebnis vor, das zu einer falschen Interpretation im Sinne einer Tiefeninformation führt.

Darüber hinaus sind die Laufzeiten in derartigen, relativ großflächigen lichtempfindlichen Pixelelementen vergleichsweise lang, so daß die Bandbreite bzw. der Grenzwert der Modulationsfrequenz üblicherweise nur im Bereich von einigen Megahertz bis maximal 100 MHz liegt. Insbesondere für die Verwendung entsprechender photoempfindlicher Detektoren, zum Beispiel in der Optoelektronik und der optischen Signalübertragung, sind Bandbreiten von mindestens 1 GHz erwünscht.

Außerdem ist eine höhere Funktionalität und ein flexibler Einsatz der PMD-Pixel und PMD-Arrays für unterschiedliche Anwendungen, z.B. Realisierung unterschiedlicher Betriebsmodi mit den gleichen Pixeln insbesondere aus wirtschaftlichen Gründen erwünscht.

In Anbetracht des Vorstehenden ist es Aufgabe der vorliegenden Erfindung, eine Vorrichtung zum Erfassen von Phase und Amplitude elektromagnetischer Wellen mit den eingangs genannten Merkmalen zu schaffen, welche eine deutlich verbesserte Bandbreite hat, bei welcher darüber hinaus Fehlinterpretationen von Hell-Dunkel-Grenzen auf abgebildeten Oberflächen weniger wahrscheinlich oder sogar ausgeschlossen sind und bei welcher eine höhere Funktionalität und Wirtschaftlichkeit in praktischen Anwendungen erreicht wird.

Diese Aufgabe siehe Anspruch 1 wird dadurch gelöst, daß die Modulationsphotogates ebenso wie die Akkumulationsgates in Form langer und schmaler, paralleler Streifen nebeneinander vorgesehen sind, die gruppenweise ein PMD-Pixel bilden und wobei die Akkumulationsgates als Auslesedioden ausgebildet sind.

Diese Ausbildung der Modulationsphotogates und der Akkumulationsgates als schmale, lange Streifen und ihre Anordnung parallel unmittelbar nebeneinander führt zu sehr kurzen Kanallängen der Gates. (Die Modulationsgate-Streifenbreite wird von der MOS-Transistortechnik her als Gatelänge bezeichnet). Die in bzw. unter den Modulationsphotogates erzeugten freien Ladungsträger driften lediglich quer zur Streifenrichtung um den kurzen Abstand der Gatelänge zu dem angrenzenden Akkumulationsgate, wobei diese Drift durch ein entsprechendes elektrisches Feld seitens der Modulationsspannung an den Modulationsphotogates unterstützt wird. Die Driftzeiten sinken dadurch z.B. unter 1 Nanosekunde, so daß dementsprechend eine nutzbare Modulationsbandbreite von 1 GHz erreichbar ist. Auch wenn die einzelnen Streifen der Modulationsphotogates und auch der Akkumulationsgates relativ schmal sind, so können sie dennoch durch ihre entsprechende Länge eine hinreichend große, lichtempfindliche Fläche bieten und darüber hinaus können selbstverständlich mehrere abwechselnd angeordnete, streifenförmige Modulationsphotogates und Akkumulationsgates nahezu unter Verdopplung des optischen Füllfaktors zu einer Einheit zusammengeschaltet werden. Auf diese Weise können durch derartige Streifenstrukturen nahezu beliebige Pixelformen und Pixelgrößen ohne Einschränkung der Modulationsbandbreite realisiert werden.

In der bevorzugten Ausführungsform der Erfindung ist vorgesehen, daß die einzelnen Modulationsphotogates eine Breite haben, die größer ist als die der jeweils angrenzenden Akkumulationsgates, wobei außerdem die Breite der Modulationsphotogates nach Möglichkeit kleiner sein sollte als die Beugungsgrenze der abbildenden Optik für das von diesen Elementen erfaßten, modulierten Lichtes, und vorzugsweise in der Größenordnung der Wellenlänge oder weniger Wellenlängen dieses Lichtes bzw. dieser elektromagnetischen Welle betragen sollte. Dies führt dazu, daß aufgrund von Beugungseffekten scharfe Hell-Dunkel-Grenzen nicht mehr zufällig auf den Bereich zwischen zwei benachbarten, im Gegentakt modulierten Modulationsphotogates verlaufen können. Vielmehr führen die kleinen Abmessungen der Modulationsphotogates in Querrichtung dazu, daß eine Schatten- oder Hell-Dunkel-Grenze über die volle Breite dieser Gates verschmiert sein muß, so daß beide benachbarte Gates gleichermaßen noch mit Licht beaufschlagt werden. Außerdem ist es bei sehr langen, entsprechend schmalen Modulationsphotogates ohnehin sehr unwahrscheinlich, daß eine Hell-Dunkel-Grenze exakt parallel zur Richtung dieser Streifen verläuft. Bei der geringsten Neigung relativ zu den Streifen werden jedoch auf jeden Fall die beiden im Gegentakt modulierten, benachbarten Modulationsphotogates im wesentlichen gleichermaßen mit Licht aus dem hellen und dem dunklen Abschnitt des jeweils abgebildeten Objektes beaufschlagt.

Die Streifenlänge der Modulationsphotogates und auch der Akkumulationsgates sollte nach Möglichkeit mindestens das Zehnfache bis Hundertfache von deren Breite betragen. Die Breite der aus mehreren Modulationsphotogates und Akkumulationsgates gebildeten Pixel sollte insgesamt in etwa in der gleichen Größenordnung liegen wie die Länge, was bedeutet, daß etwa 10 - 100 Streifen nebeneinander anzuordnen sind, von denen ca. ein Drittel Akkumulationsgates und ca. zwei Drittel Modulationsphotogates sind. In einer anderen Ausführungsform der Erfindung können jedoch zur Verbesserung des Potentialverlaufs zwischen zwei Akkumulationsgates auch jeweils drei oder gar mehr Modulationsphotogates in Form entsprechender Streifen angeordnet sein, wobei das mittlere Modulationsphotogate unmoduliert sein sollte. Bevorzugt ist außerdem eine Ausführungsform der Erfindung, bei welcher sich in Querrichtung zu den Streifen bei einem Pixel immer zwei Modulationsphotogatestreifen mit einem Akkumulationsgatestreifen abwechseln, wobei die beiden unmittelbar nebeneinander angeordneten Modulationsphotogates so geschaltet sind, daß ihr Potential im Gegentakt zueinander moduliert werden kann, wobei die Akkumulationsgates jeweils ein vorzugsweise konstantes, niedrigeres Energiepotential haben, d.h. z.B. positives

Potential für die Photoelektronen, was bewirkt, daß die unter den beiden Modulationsphotogates erzeugten Ladungsträger überwiegend zur Seite desjenigen Modulationsphotogates driften, welches den niedrigen Energiepotentialwert annimmt und von dort zu dem auf dieser Seite der beiden Streifen angeordneten Akkumulationsgate gelangen. Dabei sind die beiden Modulationsphotogatestreifen, welche jeweils beidseitig eines Akkumulationsgates angeordnet sind, im Gleichtakt moduliert, d.h. zu einem gegebenen Zeitpunkt erhält ein Akkumulationsgate Ladungsträger gleichzeitig von beiden ihm benachbarten Modulationsphotogatestreifen, während das jeweils benachbarte Akkumulationsgate zu zwei Modulationsphotogatestreifen benachbart ist, die sich zu diesem Zeitpunkt gerade auf einem höheren Potential befinden, so daß nur sehr wenige Ladungsträger zu diesem Akkumulationsgate gelangen. Dementsprechend ist auch jeweils jedes zweite Akkumulationsgate mit ein und derselben Ausleseleitung verbunden und die verbleibenden Akkumulationsgates sind mit einer anderen Ausleseleitung verbunden, wobei das Summensignal dieser beiden Leitungen die Amplitude des empfangenen Lichtes wiedergibt, während das Differenzsignal unmittelbar den Wert des Korrelationssignales angibt, das sich aus der Modulation des empfangenen Lichtes und der gleichzeitigen Modulation mit derselben Modulationsfunktion der unmittelbar benachbarten Modulationsphotogates im Gegentakt ergibt. Völlig analog geschieht dies auch im Falle der Verwendung eines dritten Modulationsphotogates, welches zusätzlich zwischen den beiden erwähnten Modulationsphotogates anzuordnen wäre und welches sich zum Beispiel auf einem konstanten mittleren Potential befinden könnte, während die beiden benachbarten Photogates mit der Modulationsspannung im Gegentakt relativ zu dem mittleren Gate angehoben und abgesenkt werden könnten. Hierdurch kann der Potentialverlauf noch etwas geglättet und die Effizienz bei der einseitigen Verschiebung der Ladungsträger je nach dem aktuellen Wert der Modulationsspannung gesteigert werden.

Erfindungsgemäß werden die Akkumulationsgates als Auslesedioden ausgeführt.
Im möglichen Spannungsauslesemodus werden die gemäß der Gegentakt-Modulationsspannungen verteilten Photoladungen auf den Kapazitäten der Akkumulationsgates - in diesem Fall auf den Sperrschichtkapazitäten der in Sperrichtung gepolten Auslesedioden (z.B. pn-Dioden oder Schottky-Dioden) - gespeichert und mit einer hochohmigen Auslesevorrichtung ermittelt.
Im hier bevorzugten Stromauslesemodus wird die ankommende Photoladung bei praktisch unverändertem Potential der Ausleseelektrode unmittelbar an die Ausleseschaltung weitergegeben. Da bei den gegenwärtig für die Anwendungen dieser Erfindung aktuellen Halbleitermaterialien die Elektronenbeweglichkeit größer ist als die der Löcher bzw. Defektelektronen, werden vorzugsweise Photoelektronen durch die Modulationsphotogate richtungsmoduliert und gemäß der Modulationsspannung auf die Akkumulationsgates bzw. Auslesedioden verteilt. In diesem Fall liegen die Anoden der Auslesedioden vorzugsweise auf gemeinsamem Massepotential, während die Kathoden auf positivem Potential liegen und als Ausleseelektroden K₊ bzw. K₋ mit der Ausleseschaltung verbunden sind.
Die zuvor erläuterten zwei Arten von Akkumulationsgates K₊ bzw. K₋ wechseln einander in einer Gruppe erfindungsgemäß parallel operierender Akkumulatorgates und Modulationsphotogates, die ein neuartiges erfindungsgemäßes PMD-Pixel höchster Bandbreite bilden, in einer Weise ab, bei der z.B. eine positive Modulationsphotogatespannung zu einer Photoladungsanreicherung an den K₊-Akkumulationsgates bzw. zu einer Photoladungsverarmung an den K-Akkumulationsgates führt, wobei die Akkumulatorgates durch die zweiseitigen Ladungsakkumulation doppelt genutzt werden und den pixelinternen optischen Füllgrad nahezu verdoppeln und die parasitären Kapazitäten merklich verringern.

In einer bevorzugten Ausführungsform der Erfindung sind zwei jeweils aus mehreren parallelen Streifen aus Modulationsphotogates und Akkumulationsgates bestehende Pixel unmittelbar nebeneinander angeordnet, hier als 2 Quadraturen-Pixel bezeichnet. Hierbei ist darauf hinzuweisen ist, daß die Pixel in Querrichtung jeweils durch ein einzelnes, in dieser Richtung an den letzten Akkumulationsgatestreifen anschließendes Modulationsphotogate abgeschlossen werden und nicht durch ein Paar, wie dies zwischen den Akkumulationsgates der Fall ist. Werden zwei solche Pixel unmittelbar nebeneinander angeordnet, so kommen diese beiden Endstreifen, die jeweils ein Modulationsphotogate je eines der beiden Pixel bilden, nebeneinander zu liegen und die beiden an sich getrennten Pixel können nunmehr so moduliert werden, daß die beiden nebeneinanderliegenden Modulationsphotogates im Gegentakt zueinander moduliert werden, was effektiv darauf hinausläuft, daß man die Pixelfläche verdoppelt bei gleicher Modulationsspannung und -phase hat und aus den zwei einzelnen Pixeln ein einheitliches, größeres Pixel gebildet hat. Da aber bei dieser Ausführungsform die beiden Hälften dieses größeren Pixels im Prinzip unabhängig voneinander moduliert werden können, kann man ebenso gut auch die Modulationsfunktion bei dem einen Pixel um 90° oder eine geeignete Verzögerung T_{D} gegenüber dem anderen Pixel in der Phase bzw. Laufzeit versetzen. Dies führt dazu, daß gleichzeitig In-Phase- und Quadratur-Signale gemessen werden, so daß man dadurch die vollständige Information über die Phasenlage der Korrelationsfunktion parallel und gleichzeitig erhält.

Die Akkumulationsgateanschlüsse sind dabei zweckmäßigerweise jeweils an der Stirnseite eines der Pixel vorgesehen. Die Modulationsphotogateanschlüsse sind vorzugsweise als Gegentaktstreifenleitungen von der von beiden Stirnseiten bzw. Streifenenden der Pixelflächen her vorgesehen, und zwar vor allem bei besonders langen Streifen zusätzlich durch quer verlaufende Gegentaktstreifenlängen jeweils mehrfach und in gleichen Abständen. Man vermeidet dadurch, daß aufgrund des elektrischen Flächenwiderstandes der Modulationsphotogates das Modulationssignal über die Länge des Gates gedämpft und verformt wird, so daß auch die ermittelte Korrelationsfunktion entsprechend verformt wird.

Besonders bevorzugt ist eine Ausführungsform der Erfindung, bei welcher vier Pixel in einem Rechteck oder Quadrat angeordnet sind und eine Einheit bilden, und zwar derart, daß die Streifen von in dem Quadrat oder Rechteck jeweils diagonal zueinander angeordneten Pixeln parallel zueinander verlaufen, während die Streifen der unmittelbar benachbart liegenden Pixel senkrecht zueinander verlaufen, wodurch insbesondere störende gegenseitige Überkopplungen weitgehend vermieden werden. Diese Ausführungsform wird hier als 4 Quadranten (4Q)-PMD-Pixel bezeichnet. Wenn die Pixel selbst quadratisch sind, so ist auch das aus den vier Quadraten zusammengesetzte Pixelelement quadratisch und man kann durch Phasenverschiebung der Modulation zwischen diagonal gegenüberliegenden Pixeln jeweils die Gegentaktkorrelationswerte der In-Phase- und Quadratur-Signale gleichzeitig erfassen.

Weiterhin ist eine Ausführungsform der Erfindung bevorzugt, bei welcher über den Modulationsphotogates und den Akkumulationsgates entsprechende, streifenförmige Linsen, konkret also Zylinderlinsen, angeordnet werden, die das auf die Linsen auftreffende Licht auf die Modulationsphotogates bündeln, so daß auch die von den nicht lichtempfindlichen Akkumulationsgates beanspruchten Oberflächenanteile effektiv noch zu der Lichtausbeute beitragen. Wenn das eingekoppelte modulierte Licht relativ schmalbandig ist, kann die Streifenstruktur für eine mittlere Wellenlänge dieses Lichts so dimensioniert werden, daß der Einkopplungsfaktor gemäß der Wellentheorie merklich größer, bzw. der Reflektionsfaktor merklich kleiner ist, als es den Reflektionsfaktoren gemäß der geometrischen Optik entspricht. Dabei kann eine Vergütung der Modulationsphotogates einbezogen werden und eine solche Maßnahme unterstützen.

Mehrere Pixel können entweder zu einem linearen Array oder zu einem Matrixarray zusammengeschaltet werden, wobei auch dabei eine Ausführungsform bevorzugt ist, bei welcher über den einzelnen Pixeln Mikrolinsen angeordnet sind, die das einfallende Licht, welches teilweise auch auf Bereiche gerichtet ist, die zwischen den Pixeln liegen und nicht zur Auswertung beitragen, durch die Mikrolinsen auf die lichtempfindlichen Pixelflächen geleitet wird. Ein 4Q-PMD-Pixel kann mit vierfach gleicher oder mit unterschiedlicher Modulation die Schwerpunkte der vier quadratischen Teilpixel vermessen und zugleich durch Mittelwertbildung aller 4 Korrelationswerte die Gesamtphase bzw. -laufzeit des 4Q-PMD-Pixels ermitteln. Die vier Einzelschwerpunktlaufzeiten liefern dabei den Gradienten oder Normalenvektor des abgebildeten Oberflächenelements und ermöglichen eine verbesserte Interpolation der zu vermessenden 3D-Oberfläche zwischen den benachbarten Pixeln eines Arrays.

Schließlich ist eine Ausführungsform der Erfindung besonders bevorzugt, bei welcher die Pixel, d.h. die einzelnen Photomodulationsgates und die Akkumulationsgates in CMOS-Technik realisiert sind. Dies ist eine sehr preiswerte und gut etablierte Technik, die eine Massenherstellung entsprechender Elemente ermöglicht und zugleich auch die Onchip- und Multichip-Modul-Integration der peripheren Elektronik wie Auswerteelektronik und Modulationselektronik erlaubt.

In CMOS-Technologie können sowohl konventionelle CMOS-Pixel mit 2D-Funktionalität (sog. 2D-Pixel) als auch PMD-Pixel mit 3D-Funktionalität (sog. 3D-Pixel) in einem linearen Array oder einem Matrixarray gemischt integriert werden. Dabei können die verschiedenen, insbesondere benachbarten Pixelinformationen in einer nachgeschalteten datenfusionierenden und interpolierenden Vorrichtung bezüglich einer schnellen Rekonstruktion des vollständigen 3D-Farb/Tiefenbildes mittels der Farbinformationen der 2D-Pixel und der 3D-Tiefen- und 2D-Grauwertinformationen der 3D-PMD-Pixel ausgewertet werden, was völlig neue Möglichkeiten in der optischen Meßtechnik und in der Automatisierung, Objektidentifikation, Sicherheitstechnik und Multimediatechnik schafft.

Weitere Vorteile, Merkmale und Anwendungsmöglichkeiten der vorliegenden Erfindung werden deutlich anhand der folgenden Beschreibung bevorzugter Ausführungsformen und der dazugehörigen Figuren. Es zeigen:
- Figur 1: eine Draufsicht auf ein Pixel gemäß einer ersten Ausführungsform der vorliegenden Erfindung,
- Figur 2: die Zusammenschaltung zweier benachbarter Pixel,
- Figur 3: einen Ausschnitt aus einem Querschnitt durch die in Figur 2 dargestellten Pixelelemente, mit einem Schnitt entlang der Linie III-II in Figur 2,
- Figur 4: eine vergrößerte Draufsicht von oben auf einen Ausschnitt des in Figur 2 dargestellten Doppelpixel bzw. 2 Quadranten-Pixel,
- Figur 5: einen Schnitt quer zur Streifenrichtung durch ein Pixel in einer anderen Ausführungsform der vorliegenden Erfindung mit jeweils drei Modulationsphotogates zwischen zwei Akkumulationsgates, sowie einer vergrabenen n-Schicht (buried n-layer) und mit im Isoliermaterial eingebetteten Modulationsphotogateelektroden Figur 6 eine Draufsicht auf die 3Gate-Struktur eines PMD-Pixels in Multi-Streifentechnik gemäß Figur 5 in einer Ansicht entsprechend Figur 4,
- Figur 7: eine perspektivische Ansicht eines Ausschnittes aus dem in den Figuren 5 und 6 dargestellten Pixels,
- Figur 8: vier mit unterschiedlichen Streifenausrichtungen zusammengeschaltete Pixelelemente, die eine Pixeleinheit für verschiedene Betriebsmodi bilden,
- Figur 9: ein Feld aus 2 x 4 Pixeln gemäß Figur 8,
- Figur 10: schematisch die Arbeitsweise einer 3D-Kamera, die aus einem größeren Feld von Pixelelementen analog zu Figur 9 aufgebaut ist,
- Figur 11: eine optische PLL-Schaltung bzw. DLL-Schaltung auf PMD-Basis für Lichtschranken, Laufzeitkameras und Datenlichtschranken mit optionaler Datensignalregeneration.
- Figur 12: eine Login-Verstärkerschaltung zur Messung von In-Phase- und Quadratur-Signalen sowie Signale mit Bandspreiztechnik insbesondere für hochempfindliche Datenlichtschranken, für Phasenlaufzeitmessungen und für die optische Datenübertragung vorzugsweise in optischen CDMA(Code Division Multiple Access)-Systemen sowie mit optionaler Datensignalregeneration,

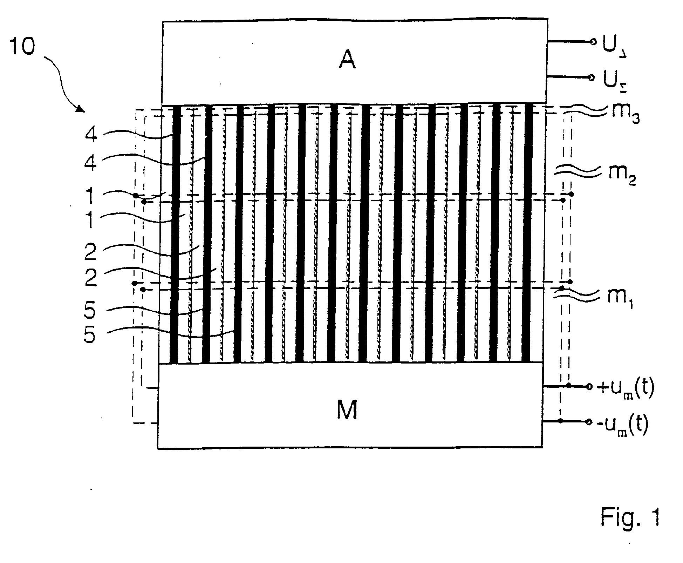

Man erkennt im mittleren Teil der Figur 1 eine Reihe paralleler, vertikaler Streifen, wobei die hellen Streifen lichtempfindliche, semitransparente Modulationsphotogates wiedergeben, während die dunklen Streifen, die mit 4 und 5 bezeichnet sind, lichtundurchlässig abgedeckten Akkumulationsgates oder Auslesegates entsprechen. Die schmalen schwarzen senkrechten Streifen repräsentieren isolierende Trennflächen zwischen benachbarten Modulationsphotogates 1 und 2.

Die Modulationsphotogates sind hier durch die Bezugszahlen 1 und 2 unterschieden, weil die Modulationsphotogates mit der gleichen Bezugszahl 1 auch im Gleichtakt miteinander moduliert werden, während das Potential der wiederum mit der untereinander gleichen Bezugszahl 2 bezeichneten Modulationsphotogates zu den Modulationsphotogates 1 im Gegentakt moduliert werden. Mit M ist im unteren Teil schematisch die Modulationsschaltung, insbesondere die Modulationselektronik und -anschlüsse 8 der Modulationsspannungsversorgung wiedergegeben. Mit A sind im oberen Teil der Figur 1 schematisch die Ausleseschaltung insbesondere die Ausleseelektronik und -anschlüsse sowie eine Signalverarbeitung bezeichnet, die mit den Akkumulationsgates 4 bzw. 5 verbunden ist. Dabei werden alle Akkumulationsgates 4, d.h. jedes zweite Akkumulationsgate mit einer ersten, gemeinsamen Ausleseleitung verbunden und die dazwischen liegenden Akkumulationsgates 5 werden mit einer anderen, gemeinsamen Ausleseleitung verbunden. Die Ausleseschaltung ermittelt das Summensignal U_{Σ} und außerdem die Differenz U aus den Photoladungen der Akkumulationsgates 4 und 5. U_{Σ} ist ein Maß für die Summe der zeitlich gemittelten gesamten Photoladungen, während U ein Maß für die Differenz der Photoladungen an den Akkumulationsgates 4 und 5 bzw. K₊ und K ist. Die Modulationsphotogates 1 sind zum Beispiel mit dem Spannungsanschluß +Uₘ(t) verbunden, wenn die Modulationsphotogates 2 mit dem Spannungsanschluß -Uₘ(t) verbunden sind. Die Modulationsspannung ist vorzugsweise eine Pseudorausch- bzw. Pseudonoise- oder aber auch eine Pseudorandom-Spannung, man könnte jedoch auch irgendein anderes codiertes Modulationssignal mit geeigneter, schmaler Korrelationsfunktion und einer hinreichenden Wortlänge verwenden.

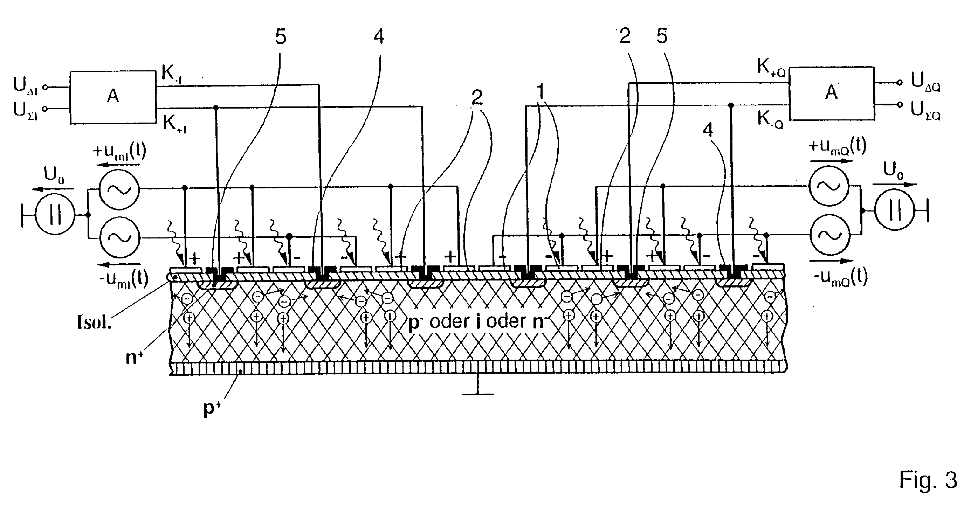

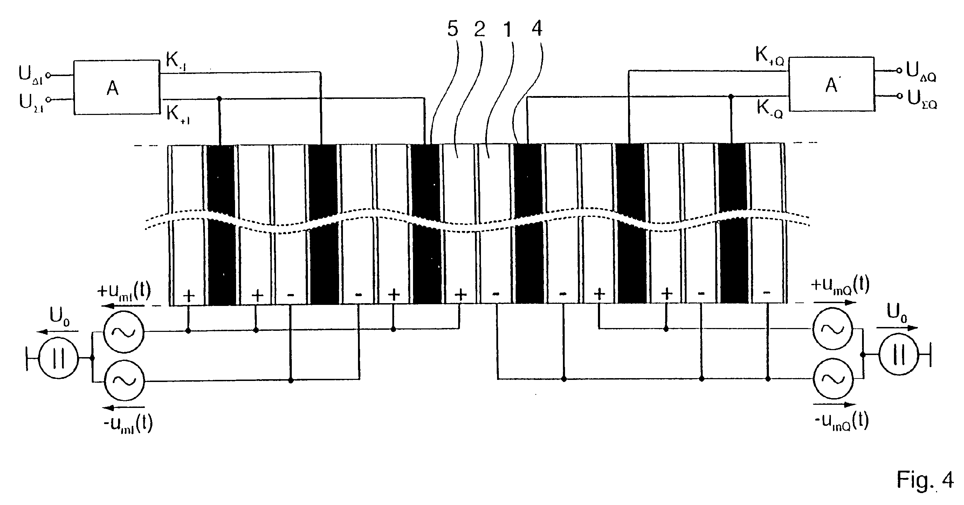

Wenn die Modulationsphotogates 1 sich auf einem niedrigen Spannungsniveau befinden, während die Modulationsphotogates 2 auf einem hohen Spannungsniveau sind, so werden die Ladungsträger, im Ausführungsbeispiel von Fig. 3 und 4 Photoelektronen, überwiegend oder nahezu ausschließlich nur zu den Akkumulationsgates 4 geleitet, während die Akkumulationsgates 5 keine oder fast keine Ladungen aufsammeln. Wenn die Spannungsverhältnisse sich umkehren, die Modulationsphotogates 1 sich also auf hohem Potential befinden, während die Modulationsphotogates 2 auf niedrigem Potential sind, so fließen die Ladungsträger nahezu ausschließlich über die Akkumulationsgates 5 ab. Bei einer starken zeitlichen Variation der entstehenden Ladungsträger, die durch die mit derselben Funktion variierende Beleuchtung eines Objektes erzeugt wird, dessen Abbild von dem Pixel aufgenommen wird, erhält man dadurch auch die Information über den Zeitpunkt, zu welchem die Ladungsträger auf den lichtempfindlichen Flächen erzeugt wurden. Die Modulation der Modulationsphotogates mit derselben Modulationsfunktion, mit der auch die Beleuchtung des Objektes moduliert wird, liefert dann als Signal U die Korrelationsfunktion, die die Informationen über den Abstand des abgebildeten Bildelementes enthält.

Wie man sieht, sind die Streifen im Vergleich zu ihrer Länge sehr schmal, wobei in den Figuren die entsprechenden Verhältnisse nicht maßstabsgetreu wiedergegeben sind. Vielmehr sind in der Praxis die einzelnen Streifen im Verhältnis zu ihrer Breite noch wesentlich länger. Die schmalen Streifen entsprechen einer sehr kurzen Gatelänge, d.h. einem sehr kurzen Driftweg für unter einem Modulationsphotogate 1 oder 2 entstehenden Ladungsträger zu einem der Auslesegates 4 oder 5. Die entsprechend kurzen Driftzeiten ermöglichen entsprechend schnelle Modulationssignale und führen damit zu einer hohen Bandbreite. Um aber die Meßgenauigkeit nicht durch den Widerstand der Modulationsphotogates in ihrer Längsrichtung zu beeinträchtigen, sind parallel mehrere Modulationsanschlüsse m₁, m₂ und m₃ jeweils im gleichen Abstand zueinander vorzugsweise von der Oberseite des Pixels her mit den jeweiligen Modulationsphotogates 1 und 2 verbunden, so daß die Modulation simultan an den jeweiligen Anschlußpunkten der Anschlußleitungen m₁, m₂ und m₃ erfolgen kann, wobei selbstverständlich die Zahl dieser Anschlüsse entsprechend den Anforderungen und entsprechend der Länge der einzelnen Streifen angepaßt und verändert werden kann. Alternativ oder zusätzlich kann diese Problematik dadurch gelöst werden, daß die an die Akkumulationsgates (4, 5) unmittelbar angrenzenden Modulationsphotogates auf der den Akkumulationsgates zugewandten Seite des Streifens teilweise eine streifenförmige Abdeckung von z.B. ein Viertel bis ein Drittel Modulationsphotogatebreite durch einen kontaktierenden Streifen hoher Leitfähigkeit und keiner oder sehr geringer Transparenz für die elektromagnetischen Wellen vorzugsweise in Form eines auf das Modulationsphotogate aufgebrachten Metallfilms erhalten, wobei diese Maßnahme auf die Fokussierung des Lichts im Pixelbereich durch die erfindungsgemäßen Zylinderlinsen abgestimmt wird.

Außerdem können die Modulationsphotogates 1 und 2 noch direkt einen stirnseitigen Anschluß von dem unten mit M gekennzeichneten Block her erhalten.

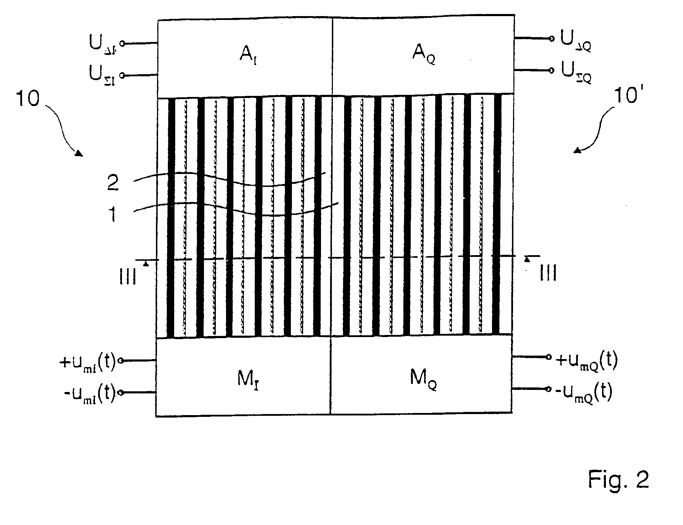

Figur 2 zeigt schematisch ein Pixel, welches aus zwei gleichen Pixelelementen 10, 10' zusammengesetzt ist, die jeweils im Vergleich zu dem Pixelelement 10 aus Figur 1 nur jeweils die halbe Breite haben. Der Klarheit wegen sind hier die zusätzlichen Modulationsanschlüsse m₁, m₂ und m₃ nicht eingezeichnet, könnten jedoch selbstverständlich ebenso vorhanden sein.

Die beiden Streifenfelder dieser Pixel 10, 10' sind unmittelbar nebeneinander angeordnet, so daß in der Mitte an der Grenzfläche zwischen den beiden Pixeln 10, 10' zwei einzelne Modulationsphotogates 2 bzw. 1 nebeneinander zu liegen kommen. Jedes der Pixel 10, 10' hat seine eigene Modulationsspannungsversorgung und auch seine eigene Ausleseschaltung und eigene Ausleseleitungen. Werden die Modulationsspannungen des Pixels 10' im Verhältnis zu denen des Pixels 10 so angelegt, daß der Streifen 2 des Pixels 10 im Gegentakt zu dem Streifen 1 des Pixels 10' moduliert wird, so wirken beide Pixelelemente zusammen ebenso wie das darüber dargestellte größere Pixel 10 gemäß Figur 1. Man kann jedoch auch die Modulationsspannung des Pixels 10' um 90 phasenversetzt zu der Modulationsspannung des Pixels 10 wählen, was einem In-Phase- und einem Quadratursignal entspricht. Dementsprechend sind hier die einzelnen Spannungen, die Modulations- und die Auswerteschaltung zusätzlich mit dem Index I für "In-Phase" und die entsprechenden Schaltungen und Spannungssymbole des Pixels 10' mit dem zusätzlichen Index Q für "Quadratur" gekennzeichnet.

Figur 3 zeigt schematisch einen konkreten physikalischen Aufbau des in Figur 2 dargestellten Doppelpixels, wobei man erkennt, daß dieses Doppelpixel auf einem gemeinsamen Substrat untergebracht ist und daß sich auch die Anordnung und Folge der einzelnen Modulationsphotogateschichten, Isolatorschichten und Akkumulationsgateschichten nicht von der Anordnung unterscheidet, die man auch bei dem größeren Pixel gemäß Figur 1 hätte. Lediglich die elektrischen Anschlüsse sind für die rechten und linken Pixelhälften vollständig voneinander getrennt, so daß es möglich ist, die Modulation der in der rechten Hälfte angeordneten Modulationsphotogates unabhängig von der Modulation der in der linken Hälfte angeordneten Modulationsphotogates zu wählen, was, wie bereits erwähnt, die Auftrennung der Signale in In-Phase- und Quadratur-Signale ermöglicht und die Vielseitigkeit des PMD-Pixel erhöht.

Figur 4 ist einfach eine Draufsicht von oben, die im wesentlichen auch der Draufsicht gemäß Figur 2 entspricht, wobei jedoch die einzelnen Streifenelemente in ihrer Länge unterbrochen dargestellt sind, um die gesamte Anordnung vergrößert darstellen zu können und wobei auch die einzelnen Anschlüsse der Modulationsphotogates an die Modulationsschaltung und auch die Anschlüsse der Ausleseschaltungen an die Akkumulationsgates 4 und 5 zusätzlich im Detail dargestellt sind.

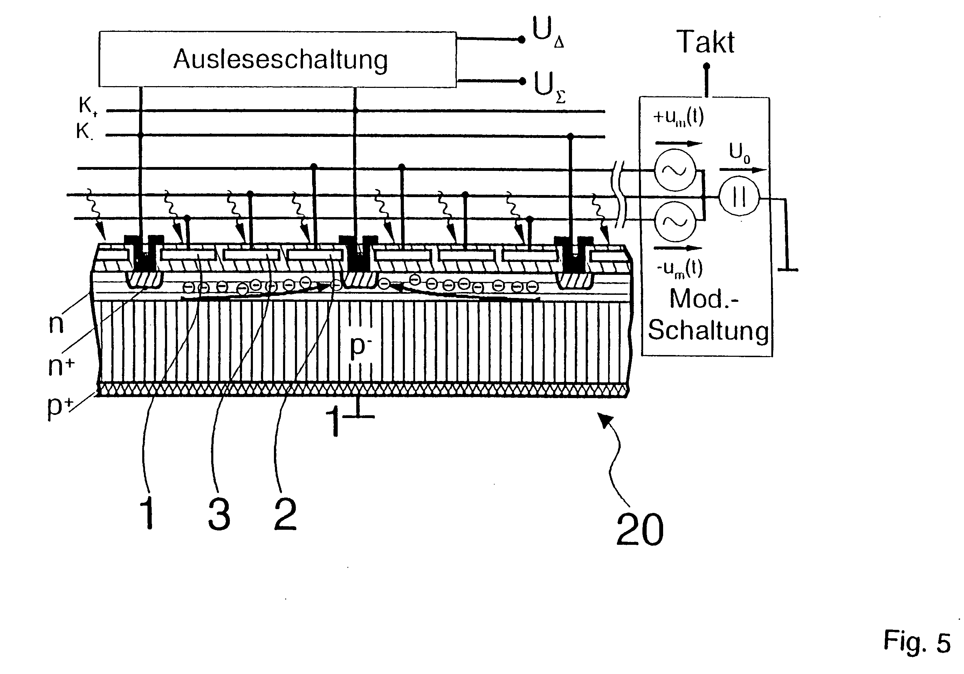

Die Figuren 5 bis 7 zeigen eine weitere alternative Ausführungsform der Erfindung, bei welcher zwischen den Modulationsphotogates 1 und 2, wie sie bereits anhand der Figuren 1 bis 4 beschrieben wurden, zusätzlich noch ein weiteres Modulationsphotogate 3 vorgesehen ist, wobei die Schaltungssymbole jeweils rechts in den Figuren 5 bis 7 andeuten, daß dieses mittlere Modulationsphotogate auf einem konstanten Potential gehalten wird und relativ hierzu die Modulationsphotogates 1 und 2 in ihrem Potential entsprechend der Modulationsfunktion angehoben und abgesenkt werden. Dies führt zu einem insgesamt geglätteten Potentialverlauf und einer noch besseren Kanaltrennung, höherer Driftgeschwindigkeit und geringerer Modulationsleistung.

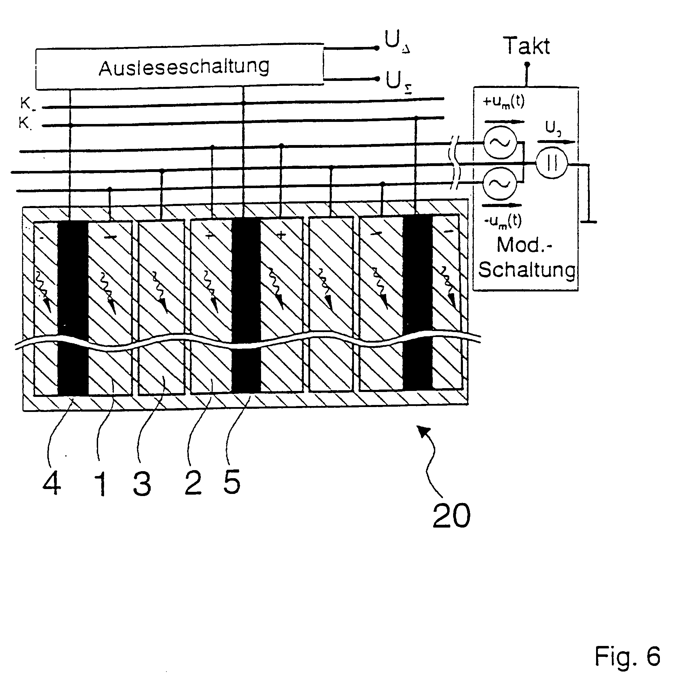

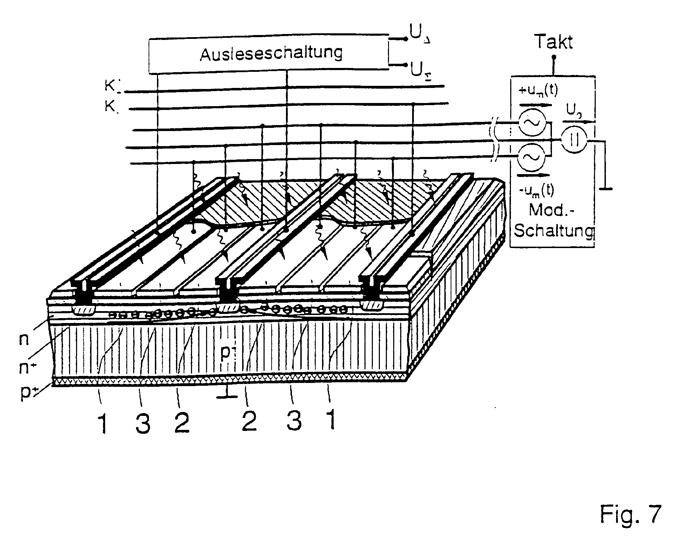

Figur 5 ist dabei eine Schnittansicht analog zu Figur 3, ohne daß jedoch hier das Pixel in mehrere Teile aufgeteilt ist. Hierbei wird eine vorteilhafte Ausführung mit einer vergrabenen n-Schicht sowie mit im Isoliermaterial eingebetteten Modulationsgateelektroden gezeigt, die für kleinste Strukturen vorteilhaft gegenüber überlappenden Gatestrukturen ist. Figur 6 zeigt eine Ansicht von oben ähnlich Figur 4 und Figur 7 zeigt eine perspektivische Ansicht dieses Photomischdetectors PMD.

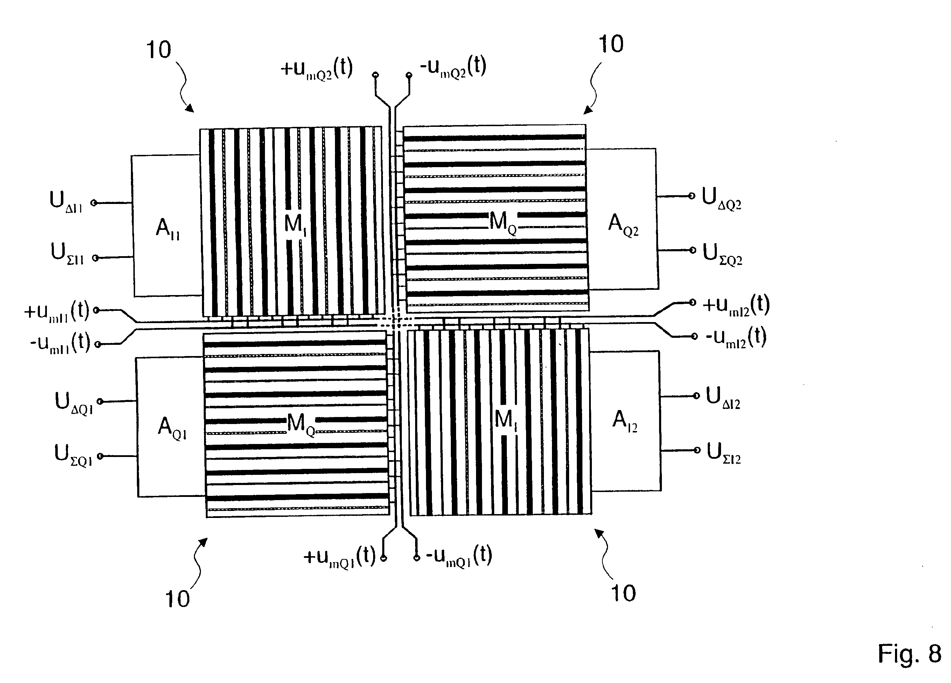

In Figur 8 erkennt man vier aus streifenförmigen Modulationsphotogates und Akkumulationsgates zusammengesetzte Pixelelemente, die jeweils eine in etwa quadratische Form haben und die zu einem insgesamt wiederum quadratischen Pixel zusammengesetzt sind, wobei die Streifen in den diagonal zueinander angeordneten Quadranten jeweils parallel zueinander verlaufen, während sie zwischen benachbarten Quadranten senkrecht zueinander verlaufen. Dadurch wird eine gegenseitige Überkopplung und Verfälschung unterschiedlicher benachbarter Modulationssignale weitgehend unterdrückt. Die Auswerteschaltungen sind dabei an diejenigen Quadratseiten verlegt, die außerhalb der quadratischen Pixelfläche angeordnet werden können. Auch hier erfolgt die Modulation der Modulationsphotogates vorzugsweise wieder mit einem Modulationsspannungssignal, welches für zwei diagonal zueinander liegenden Quadranten relativ zu den beiden anderen diagonal angeordneten Quadranten um 90 phasenversetzt ist, bzw. um eine Chipbreite T_{Chip} bei PN-Modulation verzögert ist, was wiederum zu der gleichzeitigen Messung von In-Phase- und Quadratursignalen führt. Die im Zentrum sich überschneidenden Modulationsspannungsleitungen können für 1 Quadrantenbetrieb geschlossen sein, für 2Quadrantenbetrieb können sie nur horizontal und vertikal verbunden und für getrennten 4 Quadrantenbetrieb können sie offen sein. Es ist jedoch auch vorteilhaft, bei 4 identischen Modulationssignalen und somit vorzugsweise verbundenen Leitungen vierfach getrennt auszulesen. Die erforderlichen IQ-Wertepaare für die Laufzeitbestimmung können im 1 Quadranten-Betrieb auch im Zeitmultiplex ermittelt werden. Im alternativen Heterodynverfahren können die 4 Korrelationsfunktionen mit der Schwebungsfrequenz durchlaufen und so die Abstandsinformationen ermittelt werden.

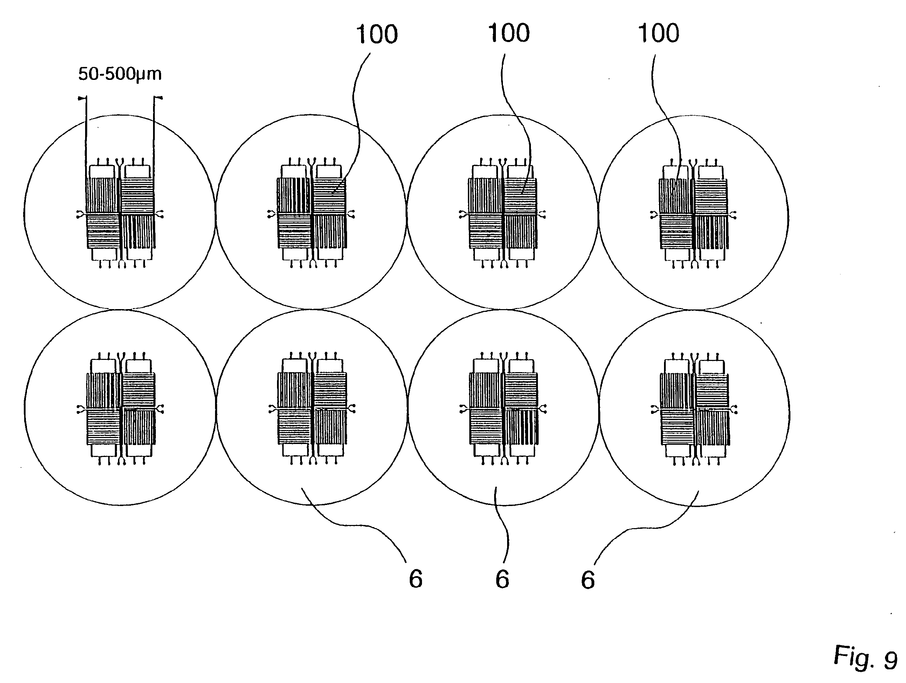

In Figur 9 ist ein Feld von 2 x 8 Pixeln der in Figur 8 dargestellten Art gezeigt. Über jedem dieser Pixel, die hier insgesamt mit 100 bezeichnet werden, ist eine Mikrolinse 6 angeordnet, welche dazu dient, das auf die von dem gesamten Pixelfeld aufgespannte Fläche auftreffende Licht weitgehend auf die eigentlichen lichtempfindlichen Flächen der Pixel zu bündeln. Nicht dargestellt sind Streifenlinsen, die parallel zu den Streifen verlaufend auf den einzelnen Pixeln angeordnet sind und die gesamte Pixelfläche so bedecken, daß das auf die Streifenlinsen auftreffende Licht nur auf die Bereiche zwischen den Akkumulationsgates, d.h. nur auf die Modulationsphotogates konzentriert wird.

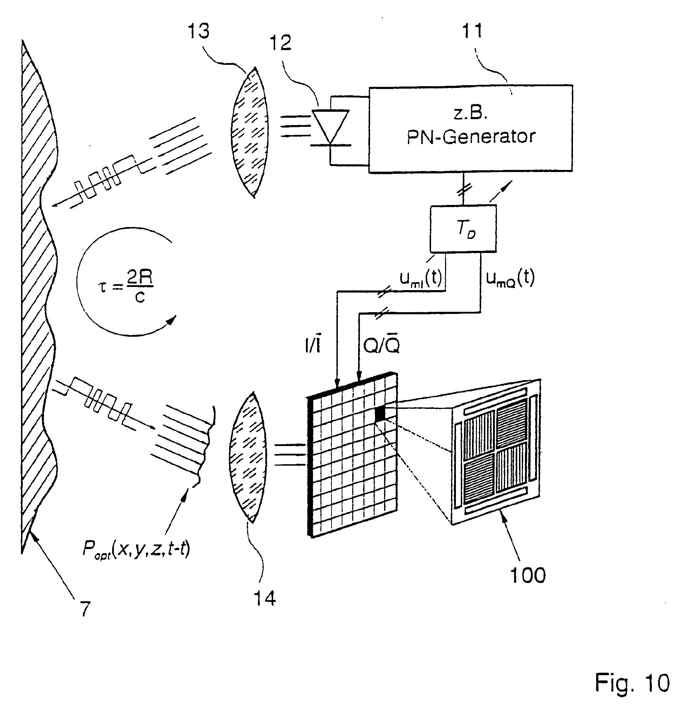

Figur 10 zeigt das Prinzip einer mit den erfindungsgemäßen Pixeln 100 ausgestatteten 3D-Kamera. Ein Generator 11, in diesem Beispiel ein PN (Pseudo Noise)-Generator, steuert einen optischen Sender, hier eine Laserdiode 12, deren Licht über eine Optik 13 auf die Oberfläche eines Objektes 7 abgebildet wird. Die Lichtintensität ist dabei mit dem Modulationssignal des Generators 11 moduliert. Das entsprechend reflektierte und gleichfalls modulierte Licht wird über eine Kameraoptik 14 auf ein Array aus Bildpixeln 100 projiziert, welche im einzelnen die Form der in Figur 8 dargestellten Pixel bzw. Photomischelemente haben können.

Diese werden mit einem Verzögerungsglied 15 mit einer einstellbaren Zeitverzögerung T_{D} für den I-Ausgang und mit einer zusätzlichen festen Verzögerung T_{chip} für den Q-Ausgang mit demselben Modulationssignal aus dem PN-Generator 11 wie auch die Laserdiode 12, allerdings im Gegentakt, moduliert. Das modulierte, empfangene Lichtsignal wird also zweifach je Pixel mit derselben Modulationsfunktion mittels der Modulationsphotogates korreliert, so daß sich hieraus Laufzeitinformationen und damit auch Abstandsinformationen von einzelnen Elementen der Oberfläche des Gegenstandes 7 ergeben.

Diese Tiefeninformationen werden bei der erfindungsgemäßen Ausgestaltung in Form langer schmaler Streifen auch nicht mehr durch Hell-Dunkel-Grenzen auf der Oberfläche des Gegenstandes 7 fehlinterpretiert.

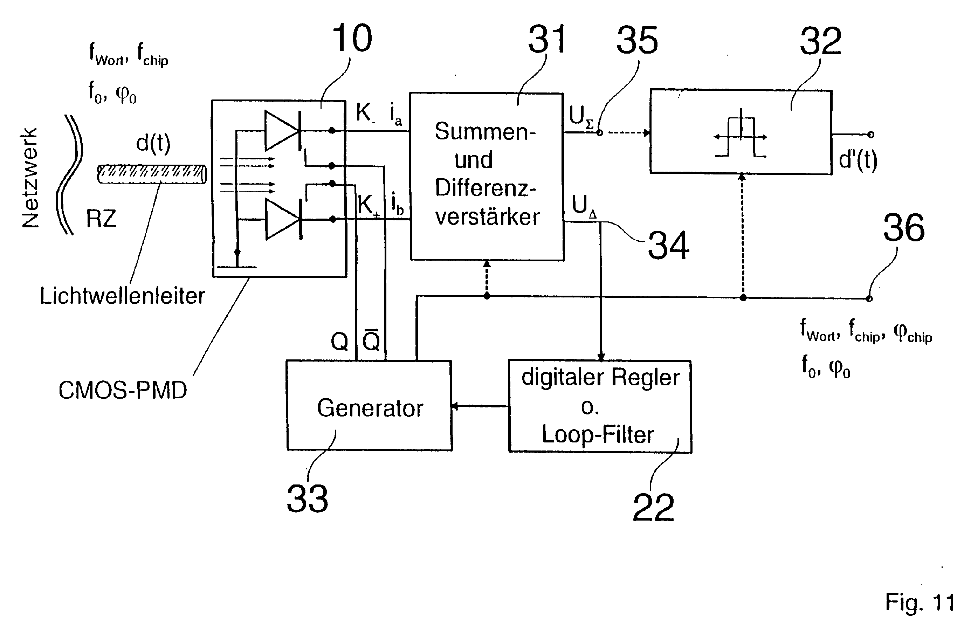

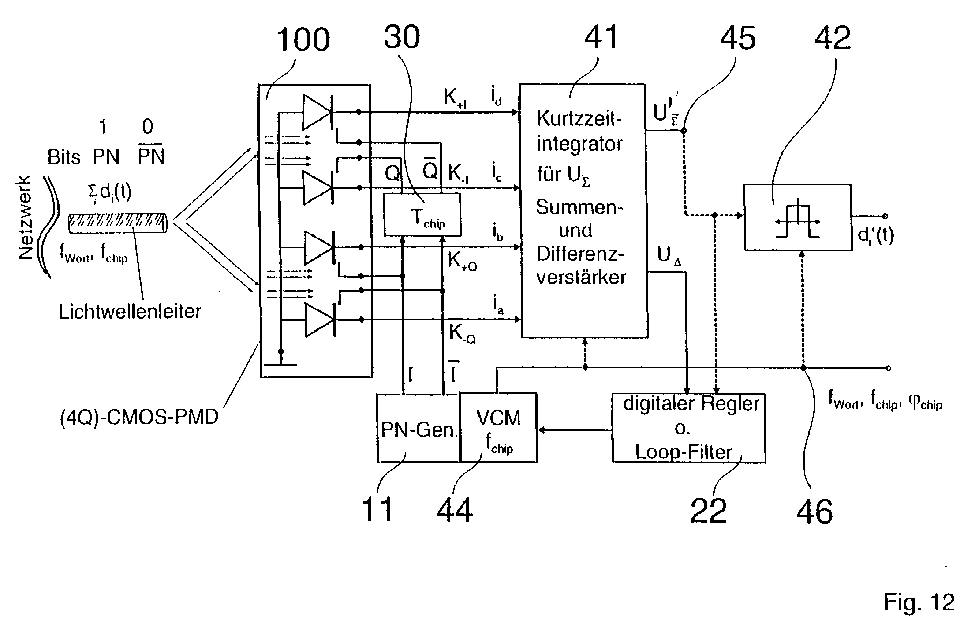

In den Figuren 11 und 12 ist die Verwendung entsprechender PMD-Elemente beim hochempfindlichen Empfang optischer Signale mit Hilfe von Phasenregelkreisen, PLL und DLL, dargestellt.
Figur 11 zeigt eine optische PLL-Schaltung bzw. DLL-Schaltung mit einem PMD-Pixel als elektrooptisches Mischelement, die über eine sehr hohe Empfindlichkeit verfügt, wie sie in Lichtschranken, als PLL-Array in Laufzeitkameras, in optischen Fernsteuerungen und in Datenlichtschranken sowie für die Regeneration von Datensignalen in der optischen Nachrichtenübertragung vorteilhaft einsetzbar ist. Ein optischer PMD-PLL ist hochintegrierbar, da der übliche Empfangs-HF-Verstärker, der der Photodiode nachgeschaltet ist sowie der elektronische Mischer vollständig entfällt, weil der Photomischdetektor PMD mit der Ausleseschaltung 31 am Ausgang 34 bereits das Mischprodukt im Niederfrequenzbereich als tiefpaßgefiltertes Differenzsignal U_{Δ} = const.·(iₐ-i_{b}) zur Verfügung stellt. Über ein Schleifenfilter (Loop-Filter) oder einen digitalen Regler schließt sich der Phasenregelkreis.
Er kann für viele Modulationsarten eingesetzt werden, z.B. für Sinus-, Rechteck-, Frequenz-, Phasen-Modulation und für Codemultiplex, z.B. PN-Codierung. Dabei wird der spannungsgesteuerte Generator 33 auf die zu empfangene Modulation und Taktrate eingestellt. Wenn der Phasenregelkreis eingerastet ist, können mit einem 1/0-Entscheider 32 durch eine derartige Taktrückgewinnung Datensignale, die beim erfindungsgemäßen breitbandigen PMD an einem breitbandigen Summenausgang 35 der Ausleseschaltung 31 oder über eine parallel mit dem gleichen optischen Datensignal angesteuerte Breitband-Photodiode mit Verstärker auftreten, regeneriert werden. Dazu sind die optischen 1/0-Datensignale vorzugsweise als Return-to-Zero(RZ)-Signale codiert.

Fig. 12 zeigt einen 2Q-PMD-DLL , mit dem noch höhere Empfindlichkeiten auf der Basis eines IQ-PMD-Empfängers insbesondere mit PN-Modulation erreicht werden.
Wie in den dieser Patentanmeldung zugrundeliegenden, eingangs erwähnten Patentanmeldungen des gleichen Anmelders ausgeführt, bietet die periodische PN-Modulation beim PMD-Empfang große Vorteile, insbesondere die Möglichkeit der Mehrkanalselektivität, der Mehrzieldetektion und der höchsten Empfindlichkeit in der Phasenlaufzeitauflösung.
Erfindungsgemäß können auch PN-codierte Datensignale für Datenlichtschranken inklusive Abstandsmessung und für die optische CDMA-Datenübertragung z.B. gemäß Fig. 12 eingesetzt werden. Dabei entspricht z.B. eine logische "1" einem normalen PN-Wort, eine logische "0" dagegen entspricht dem invertierten PN-Wort = *P̅N̅ ,* d. h. die Hell/Dunkel-Chips werden vertauscht. Im Unterschied zu Fig. 11 wird in Fig. 12 die Differenzausgangsspanng als Differenz der Betragsdifferenzen der Photoströme gebildet: U_{Δ} = const-(|iₐ-i_{b}| - |i_{c}-i_{d}|).
Mit Hilfe des rückgewonnenen Worttaktes kann das Datensignal der PN-codierten 1/0-Datenfolge regeneriert werden, indem im Summenverstärker die Summe der Differenzen der Photoströme U_{Σ} = const-(|iₐ-i_{b}| + |i_{c}-i_{d}|) jeweils über eine PN-Wortlänge mit Hilfe eines im Summenverstärker enthaltenen Kurzzeit-Integrators gebildet und im 1/0-Entscheider taktsynchron die 1/0-Entscheidung für die nachfolgenden Auswertung oder Regeneration getroffen wird.

Mit einem VCO mit Sinusmodulation für die Modulationsspannung und mit T_{chip} = T/4 der Sinusperiode kann auch Vektormodulation detektiert und regeneriert werden.

## Patentansprüche

1. Vorrichtung zur Erfassung von Phase und Amplitude elektromagnetischer Wellen, mit mindestens zwei für die elektromagnetischen Wellen licht empfindlichen Modulationsphotogates (1, 2) und diesen zugeordneten, nicht lichtempfindlichen Akkumulationsgates (4, 5), und mit elektrischen Anschlüssen für die Modulationsphotogates (1, 2) und die Akkumulationsgates (4, 5), so daß letztere mit einer Ausleseeinrichtung und erstere mit einer Moduliereinrichtung verbindbar sind, welche das Potential der Modulationsphotogates relativ zueinander und relative zu dem, vorzugsweise konstanten, Potential der Akkumulationsgates entsprechend einer gewinschten Modulationsfunktion anhebt und absenkt wobei die Akkumulationsgates als Auslesedioden mit vorzugsweise jeweils der Kathode als Ausleseelektrode ausgeführt sind, **dadurch gekennzeichnet, daß** mehrere Modulationsphotogates (1, 2) und Akkumulationsgates in Form langer und schmaler, paralleler Streifen, deren Streifenlänge ein Mehrfaches ihrer Breite beträgt, vorgesehen sind, die gruppenweise ein Photomischdetektor-Pixel-Element bilden und wobei jedes zweite Akkumulationsgate mit ein und der selben Ausleseleitung verbunden ist und die dazwischen liegenden Akkumulationsgates mit einer anderen Ausleseleitung verbunden sind.

2. Vorrichtung nach Anspruch 1, **dadurch gekennzeichnet, daß** die Breite der Modulationsphotogates grösser ist als die Breite der Akkumulationsgates

3. Vorrichtung nach Anspruch 1 oder 2, **dadurch gekennzeichnet, daß** die Breite der einzelnen Modulationsphotogates in der Grössenordnung der Wellenlänge oder insbesondere für den fernen infrarotbereich auch kleiner ist als die Wellenlänge der elektromagnetischen Strahlung, für welche die Modulationsphotogates empfindlich sind.

4. Vorrichtung nach einem der Ansprüche 1 bis 3, **dadurch gekennzeichnet, daß** die Streifenlänge der Modulationsphotogates (1,2) und der Akkumulationsgates (4,5) mehr als das Zehnfache und vorzugsweise mehr als das Fünfzigfache der Wellenlänge der elektromagnetischen Strahlung betragen, für welche die Modulationsphotogates empfindlich sind.

5. Vorrichtung nach einem der Ansprüche 1 bis 4, **dadurch gekennzeichnet, daß** eine Mehrzahl von Modulationsphotogates paarweise parallel nebeneinander vorgesehen sind, wobei jedes der Modulationsphotogates (1, 2) eines solches Paares mit einem anderen Modulationsanschluss verbunden ist, so daß die Modulationsphotogates (1, 2) im Gegentakt modulierbar sind, wobei zwischen einem Paar von Modulationsphotogates (1, 2) und einem nächst benachbarten weiteren Paar von Modulationsphotogates (2, 1) jeweils ein Akkumulationsgate (5, 4) angeordnet ist und wobei die jeweils einem Akkumulationsphotogate (4, 5) unmittelbar benachbarten Modulationsphotogates (1, 2) der beiden Paare derart mit den Modulafonsanschlüssen verbunden bzw. elektrisch so geschaltet sind, daß ihre Modulation jeweils im Gleichtakt erfolgt.

6. Vorrichtung nach einem der Ansprüche 1 bis 5, **dadurch gekennzeichnet, daß** mehrere Modulationsanschlüsse (m1, m2, m3) unter im wesentlichen gleichen Abständen entlang der Länge der Streifen angeordnet und mit den Modulationsphotogates (1,2) verbunden sind.

7. Vorrichtung nach einem der Ansprüche 1 bis 6, **dadurch gekennzeichnet, daß** die an die Akkumulationsgates (4,5) unmittelbar angrenzenden Modulationsphotogates auf der den Akkumulationsgates zugewandten Seite teilweise eine Abdeckung durch einen kontaktierenden Streifen hoher Leitfähigkeit und keiner oder sehr geringer Transparenz für die elektromagnetischen Wellen erhält

8. Vorrichtung nach einem der Ansprüche 1 bis 7, **dadurch gekennzeichnet, daß** die Vorrichtung ein oder mehrere Pixelelemente aufweist, wobei ein Pixelelement aus mehreren Paaren von Modulationsgates (1, 2) und Akkumulationsgates (4, 5) besteht, wobei die Streifenrichtungen benachbarter Pixelelemente bei unterschiedlichen Modulationsspannungen vorzugsweise senkrecht zueinanderausgeführt und wobei quer zur Streifenrichtung die Enden des Pixels durch mindestens je ein Modulationsphotogate (1, 2) definiert werden, welches an ein nächst innen liegendes Akkumulationsgate (4, 5) anschließt.

9. Vorrichtung nach Anspruch 8, **dadurch gekennzeichnet, dass** die Akkumulationsgateanschlüsse jeweils an einer Stirnseite der Streifen eines Pixels vorgesehen sind, wobei jedes zweite Akkumulationsgate mit je einer von zweiAusleseleitungen verbunden ist und die übrigen Akkumulationsgates mit der jeweils anderen der Anschlussleitungen verbunden sind, wobei die Ausleseleitungen zu einer Auswerteschaltung führen.

10. Vorrichtung nach Anspruch 8 oder 9, **dadurch gekennzeichnet, daß** zwei Pixelelemente (10, 10') mit Ihren Streifen parallel und unmittelbar nebeneinander angeordnet sind, so daß die einander unmittelbar benachbarten Modulationsphotogates, die die nebeneinander angeordneten Enden bzw. Seiten der beiden Pixelelemente (10, 10') definieren, ein Paar von Modulationsphotogates (1, 2) bilden, welches wahlweise im Gegentakt oder phasenversetzt modulierbar ist, wodurch entweder ein einziges Pixelelement der doppelten Größe gebildet wird oder aber zwei unabhängige Messungen, zum Beispiel eines In-Phase-Signals und eines Quadratur-Signals, mit den beiden Pixelelementen möglich ist.

11. Vorrichtung nach einem der Ansprüche 8 oder 9, **dadurch gekennzeichnet, daß** vier Pixelelemente in einem Rechteck angeordnet sind, wobei die Streifen der diagonal in dem Rechteck gegenüberliegenden Pixel jeweils parallel zueinander verlaufen, während die Streifen der unmittelbar benachbarten Pixelelemente senkrecht zueinander verlaufen, und wobei die Modulationsanschlüsse derart geschaltet sind, daß die Modulation benachbarter Pixelelemente (10) phasenversetzt, und zwar vorzugsweise um jeweils 90° erfolgen kann.

12. Vorrichtung nach Anspruch 9, **dadurch gekennzeichnet, daß** jedes der Pixelelemente (10) jeweils eine in etwa quadratische Form hat und die vier Pixelelemente zu einem Quadrat zusammengesetzt sind, oder daß die Ecken zusätzlich so abgeschnitten werden, daß in etwa eine Oktaederform entsteht.

13. Vorrichtung nach Anspruch 12, **dadurch gekennzeichnet, daß** die vier Pixelelemente wahlweise einzeln oder zweifach diagonal zusammengefaßt oder vierfach zusammengefaßt sind, wobei im Falle des 4Quadranten-Betriebes und des 2Quadranten-Betriebes zusätzlich der Gradient bzw. Normalenvektor des Oberflächenelementes ausgewertet wird.

14. Vorrichtung nach einem der Ansprüche 1 bis 12, **dadurch gekennzeichnet, daß** die Modulationsphotogates und Akkumulationsgates und die zugehörige Signalauswertungsperipherie und Modulationsperipherie teilweise on-chip und teilweise als Multi-Chip-Modul in CMOS-Technologie oder in BICMOS-Technologie hergestellt sind.

15. Vorrichtung nach einem der Ansprüche 1 bis 14, **dadurch gekennzeichnet, daß** über den Modulationsphotogates (1, 2) Streifenlinsen angeordnet sind, welche im wesentlichen das gesamte auf die Fläche eines Pixelelementes fallende Licht ausschüeßlich auf die Modulationsphotogates (1, 2) bündeln.

16. Vorrichtung nach einem der Ansprüche 1 bis 15, **dadurch gekennzeichnet, daß** mehrere Pixel in einem linienförmigen oder matrixförmlgen Array angeordnet sind.

17. Vorrichtung nach einem der Ansprüche 1 bis 16, **dadurch gekennzeichnet, daß** in einem linienförmigen oder matrixförmigen Array sowohl Photomischdetektor-Pixel mit 3D-Funktionalität als auch konventionelle CMOS-Pixel mit 2D-Funktionalität gemischt eingesetzt werden, wobei die verschiedenen, insbesondere benachbarten Pixelinformationen an eine datenfusionierende und interpolierende Vorrichtung zur Rekonstruktion des Tiefenbildes geleitet werden.

18. Vorrichtung nach Anspruch 16 und 17, **dadurch gekennzeichnet, daß** vorzugsweise jedem PMD-Pixel eine Mikrolinse zugeordnet ist, welche das auf das Array fallende Licht im wesentlichen auf die lichtempfindliche Fläche der einzelnen Pixel konzentriert.

19. Vorrichtung nach einem der Ansprüche 1 bis 18, **dadurch gekennzeichnet, daß** sie zur Erfassung elektromagnetischer Wellen im optischen Bereich, im nahen Infrarot-Bereich oder im Ultraviolett-Bereich vorgesehen ist.

20. Vorrichtung nach einem der Ansprüche 1 bis 19, **dadurch gekennzeichnet, daß** die Akkumulationsgates als Auslesedioden mit der Kathode als Ausleseelektrode ausgeführt sind.

21. Verwendung einer Vorrichtung nach einem der Ansprüche 1 bis 20, **dadurch gekennzeichnet, daß** die Vorrichtung als lichtempfindliches Bildaufnahmeelement in einer Kamera Verwendung findet

22. Anwendung der Vorrichtung nach einem der Ansprüche 1 bis 20, **dadurch gekennzeichnet, daß** die Vorrichtung in der optischen Signalverarbeitung als frequenz- und phasenempfindliches Misch-bzw. Korrelationselement zur Signalgewinnung, -verarbeitung und Rauschunterdrückung verwendet wird.

23. Verfahren zum Betreiben einer Vorrichtung nach einem der Ansprüche 1 bis 20, **dadurch gekennzeichnet, daß** eine abzubildende Szene mit einem entsprechend einer Modulationsfunktion modulierten Licht beleuchtet wird, wobei die Modulationsphotogates (1, 2) mit derselben jetzt allerdings bipolaren bzw. Gegentakt-Modulationsfunktion moduliert werden und wobei wahlweise für eine Hälfte eines 2 Quadranten- oder 4 Quadranten-Pixels der Pixel auch eine um 90° phasenversetzte Modulation bei Sinusmodulation oder eine Bitbreite bei Rechteckmodulation oder eine Chipbreite bei PN-Modulation der Modulationsphotogatespannungen erfolgt.

24. Verwendung einer Vorrichtung nach einem derAnsprüche 1 bis 20, **dadurch gekennzeichnet, dass** die Vorrichtung in einer optischen PLL-Schaltung bzw. DLL-Schaltung Verwendung findet, die vorzugsweise hochintegriert wird und vorzugsweise in Lichtschranken, als PLL-Array in Laufzeitkameras, in optischen Fernsteuerungen und in Datenlichtschranken sowiefür die Regeneration von Datensignalen in der optischen Nachrichtenübertragung mit verschiedenen Modulationsarten eingesetzt wird.

25. Verwendung einer Vorrichtung nach einem der Ansprüche 1 bis 20 und 24, **dadurch gekennzeichnet, daß** die Vorrichtung in einer optischen PLL- bzw. DLL-Schaltung mit einem 2 Quadranten-Photomischdetektor -DLL auf der Basis eines IQ-Photomischdetektor-Empfängers insbesondere mit PN-Modulation Verwendung findet, wobei digitale PN-codierte Datensignale zur Mehrkanalselektion, Mehfachzieldetektion und für höchste Empfindlichkeit in der Phasenlaufzeitauflösung eingesetzt werden, wobei die Differenzausgangsspannung als Differenz der Betragsdifferenzen der Photoströme als U_{Δ} = const (|iₐ-i_{b}| - |i_{c}-i_{d}| gebildet und über einen Schleifenfilter oder einen digitalen Regler als Stellgröße des spannungsgesteuerten Multivibrators der Chipfrequenz zurückgeführt wird und wobei mit Hilfe des rückgewonnenen Worttaktes das Datensignal der PN-codierten 1/0-Datenfolge regeneriert wird, indem im Summenverstarker (41) die Summe der Differenzen der Photoströme U'_{Σ} = const (|i_{c}-i_{b}| + |i_{c}-i_{d}|) jeweils über eine PN-Wortlänge mit Hilfe eines im Summenverstärker enthaltenen Kurzzeit-Integrators gebildet wird.

## Claims

1. Apparatus for detecting the phase and amplitude of electromagnetic waves, comprising at least two modulation photogates (1, 2) which are photosensitive to the electromagnetic waves and accumulation gates (4, 5) which are associated with the modulation photogates and which are not photosensitive, and electrical connections for the modulation photogates (1, 2) and the accumulation gates (4, 5) so that the latter can be connected to a reading-out device and the former can be connected to a modulating device which increases and reduces the potential of the modulation photogates (1, 2) relative to each other and relative to the preferably constant potential of the accumulation gates (4, 5) corresponding to a desired modulation function, wherein the accumulation gates are in the form of reading-out diodes with preferably in each case the cathode as the reading-out electrode **characterised in that** there are provided a plurality of modulation photogates (1, 2) and accumulation gates (4, 5) in the form of long narrow parallel strips whose strip length is a multiple of their width and which group-wise form a photomixing detector pixel element and wherein each second accumulation gate is connected to one and the same reading-out line and the accumulation gates therebetween are connected to another reading-out line.

2. Apparatus according to claim 1 **characterised in that** the width of the modulation photogates is greater than the width of the accumulation gates.

3. Apparatus according to claim 1 or claim 2 **characterised in that** the width of the individual modulation photogates is of the order of magnitude of the wavelength or in particular for the remote infrared range also less than the wavelength of the electromagnetic radiation to which the modulation photogates are sensitive.

4. Apparatus according to one of claims 1 to 3 **characterised in that** the strip length of the modulation photogates (1, 2) and the accumulation gates (4, 5) is more than ten times and preferably more than fifty times the wavelength of the electromagnetic radiation to which the modulation photogates are sensitive.

5. Apparatus according to one of claims 1 to 4 **characterised in that** there are provided a plurality of modulation photogates in paired parallel mutually juxtaposed relationship, wherein each of the modulation photogates (1, 2) of such a pair is connected to another modulation connection so that the modulation photogates (1, 2) are modulatable in push-pull relationship, wherein a respective accumulation gate (5, 4) is arranged between a pair of modulation photogates (1, 2) and a next adjacent further pair of modulation photogates (2, 1) and wherein the modulation photogates (1, 2) of the two pairs, which are immediately adjacent to a respective accumulation photogate (4, 5), are connected or electrically joined to the modulation connections in such a way that their modulation occurs respectively in push-pull mode.

6. Apparatus according to one of claims 1 to 5 **characterised in that** a plurality of modulation connections (m₁, m₂, m₃) are arranged at substantially equal spacings along the length of the strips and are connected to the modulation photogates (1, 2).

7. Apparatus according to one of claims 1 to 6 **characterised in that** the modulation photogates immediately adjoining the accumulation gates (4, 5), on the side towards the accumulation gates, partially involve a covering by a contacting strip of high conductivity and of no or very low transparency for the electromagnetic waves.

8. Apparatus according to one of claims 1 to 7 **characterised in that** the apparatus has one or more pixel elements, wherein a pixel element comprises a plurality of pairs of modulation gates (1, 2) and accumulation gates (4, 5), wherein the strip directions of adjacent pixel elements at different modulation voltages are preferably perpendicular to each other and wherein transversely with respect to the strip direction the ends of the pixel are defined by at least one respective modulation photogate (1, 2) which adjoins a next inwardly disposed accumulation gate (4, 5).

9. Apparatus according to claim 8 **characterised in that** the accumulation gate connections are provided at a respective end of the strips of a pixel, wherein each second accumulation gate is connected to a respective one of two reading-out lines and the other accumulation gates are connected to the respective other one of the connection lines, wherein the reading-out lines lead to an evaluation circuit.

10. Apparatus according to claim 8 or claim 9 **characterised in that** two pixel elements (10, 10') are arranged with their strips parallel and in directly mutually juxtaposed relationship so that the mutually immediately adjacent modulation photogates which define the mutually juxtaposed ends or sides of the two pixel elements (10, 10') form a pair of modulation photogates (1, 2) which are modulatable selectively in push-pull mode or phase-displaced relationship, whereby either a single pixel element of double the size is formed or two independent measurement procedures, for example of an in-phase signal and a quadrature signal, are possible with the two pixel elements.

11. Apparatus according to one of claims 8 and 9 **characterised in that** four pixel elements are arranged in a rectangle, wherein the strips of the pixels which are disposed in diagonally opposite relationship in the rectangle respectively extend parallel to each other while the strips of the immediately adjacent pixel elements extend perpendicularly to each other, and wherein the modulation connections are connected in such a way that modulation of adjacent pixel elements (10) can be effected in phase-shifted relationship, more specifically preferably through 90° in each case.

12. Apparatus according to claim 9 **characterised in that** each of the pixel elements (10) is respectively of a substantially square shape and the four pixel elements are assembled to form a square or that the corners are additionally cut off in such a way that substantially an octahedron shape is formed.

13. Apparatus according to claim 12 **characterised in that** the four pixel elements are selectively combined individually or doubly in diagonal relationship or in quadruple relationship, wherein in the case of 4-quadrant operation and 2-quadrant operation the gradient or normal vector of the surface element is additionally evaluated.

14. Apparatus according to one of claims 1 to 12 **characterised in that** the modulation photogates and the accumulation gates and the associated signal evaluation peripheral equipment and modulation peripheral equipment are produced in part on-chip and in part as a multi-chip module using CMOS-technology or BICMOS-technology.

15. Apparatus according to one of claims 1 to 14 **characterised in that** arranged over the modulation photogates (1, 2) are strip lenses which focus substantially all the light incident on the surface of a pixel element exclusively on to the modulation photogates (1, 2).

16. Apparatus according to one of claims 1 to 15 **characterised in that** a plurality of pixels are arranged in a linear or matrix array.

17. Apparatus according to one of claims 1 to 16 **characterised in that** in a linear or matrix array both photomixing detector pixels with 3D-functionality and also conventional CMOS-pixels with 2D-functionality are used in mixed mode, wherein the various and in particular adjacent items of pixel information are passed to a data-fusioning and interpolating device for reconstruction of the depth image.

18. Apparatus according to claim 16 and claim 17 **characterised in that** preferably there is associated with each PMD pixel a microlens which concentrates the light incident on the array substantially on to the photosensitive surface of the individual pixels.

19. Apparatus according to one of claims 1 to 18 **characterised in that** it is provided for detecting electromagnetic waves in the optical range, in the near infrared range or in the ultraviolet range,

20. Apparatus according to one of claims 1 to 19 **characterised in that** the accumulation gates are in the form of reading-out diodes with the cathode as the reading-out electrode.

21. Use of an apparatus according to one of claims 1 to 20 **characterised in that** the apparatus is used as a photosensitive image-recording element in a camera.

22. Use of the apparatus according to one of claims 1 to 20 **characterised in that** the apparatus is used in optical signal processing as a frequency- and phase-sensitive mixing or correlation element for signal acquisition, processing and noise suppression.

23. A method of operating an apparatus according to one of claims 1 to 20 **characterised in that** a scene of which an image is to be produced is illuminated with a light modulated in accordance with a modulation function, wherein the modulation photogates (1, 2) are modulated with the same but now bipolar or push-pull modulation function and wherein selectively for half of a 2-quadrant or 4-quadrant pixel of the pixels 90° phase-shifted modulation is effected in the case of sine modulation or a bit width in the case of rectangular modulation or a chip width in the case of PN-modulation of the modulation photogate voltages.

24. Use of an apparatus according to one of claims 1 to 20 **characterised in that** the apparatus is used in an optical PLL-circuit or DLL-circuit which is preferably highly integrated and is preferably used in light barrier arrangements, as a PLL-array in time lapse cameras, in optical remote controls and in data light barrier arrangements and for the regeneration of data signals in optical communications with various modulation modes.

25. Use of an apparatus according to one of claims 1 to 20 and 24 **characterised in that** the apparatus is used in an optical PLL- or DLL-circuit with a 2Q-photomixing detector-DLL on the basis of an IQ-photomixing detector receiver, in particular with PN-modulation, wherein digital PN-encoded data signals are used for multi-channel selection, multi-target detection and for highest sensitivity in phase transit time resolution, wherein the difference output voltage is formed as the difference of the quantitative differences of the photocurrents as U_{Δ} = const · (|iₐ-i_{b})| - |i_{c}-i_{d}|) and is fed back by way of a loop filter or a digital regulator as a control parameter of the voltage-controlled multivibrator to the chip frequency and wherein the data signal of the PN-encoded 1/0-data sequence is regenerated by means of the recovered word clock by a procedure whereby in the summing amplifier (41) the sum of the differences of the photocurrents U'_{Σ} = const · (|iₐ-i_{b})| - |i_{c}-i_{d}|) is respectively formed over a PN-word length by means of a short-term integrator contained in the summing amplifier.

## Revendications

1. Dispositif pour la détection de phase et d'amplitude d'ondes électromagnétiques, comprenant au moins deux photogrilles de modulation (1, 2) photosensibles aux ondes électromagnétiques, auxquelles sont associées des grilles d'accumulation (4, 5) non photosensibles, et des connexions électriques pour les photogrilles de modulation (1, 2) et les grilles d'accumulation (4, 5) de sorte que les dernières peuvent être reliées à un système de lecture et les premières à un système de modulation, lequel augmente et diminue le potentiel des photogrilles de modulation (1, 2) les unes par rapport aux autres et par rapport au potentiel, de préférence constant, des grilles d'accumulation selon une fonction de modulation désirée, les grilles d'accumulation étant réalisées sous forme de diodes de lecture dont chaque cathode est, de préférence, configurée en tant qu'électrode de lecture, **caractérisé en ce que** sont prévues plusieurs photogrilles de modulation (1, 2) et grilles d'accumulation (4, 5) se présentant sous forme de bandes parallèles longues et étroites, dont la longueur est égale à un multiple de leur largeur, et qui forment par groupes un pixel de photodétecteur mixte, une grille d'accumulation sur deux étant reliée à une seule et même ligne de lecture et la grille d'accumulation située entre deux étant reliée à une autre ligne de lecture.

2. Dispositif selon la revendication 1, **caractérisé en ce que** la largeur des photogrilles de modulation est supérieure à la largeur des grilles d'accumulation.

3. Dispositif selon la revendication 1 ou 2, **caractérisé en ce que** la largeur des différentes photogrilles de modulation de l'ordre de grandeur de la longueur d'onde ou en particulier pour le domaine infrarouge lointain, est également plus petite que la longueur d'onde du rayonnement électromagnétique auquel sont sensibles les photogrilles de modulation.

4. Dispositif selon l'une des revendications 1 à 3, **caractérisé en ce que** la longueur de bande des photogrilles de modulation (1, 2) et des grilles d'accumulation (4, 5) correspond à plus de dix fois, et de préférence à plus de cinquante fois, la longueur d'onde du rayonnement électromagnétique auquel sont sensibles les photogrilles de modulation.

5. Dispositif selon l'une des revendications 1 à 4, **caractérisé en ce qu'**une pluralité de photogrilles de modulation sont prévues par paires côte à côte et parallèles entre elles, chacune des photogrilles de modulation (1, 2) d'une telle paire étant reliée à une autre connexion de modulation de sorte les photogrilles de modulation (1, 2) sont modulables symétriquement, une grille d'accumulation (5, 4) étant respectivement disposée entre une paire de photogrilles de modulation (1, 2) et une autre paire immédiatement adjacente de photogrilles de modulation (2, 1) et les photogrilles de modulation (1, 2) des deux paires respectivement directement adjacentes à une photogrille d'accumulation (4, 5) étant reliées ou connectées électriquement aux connexions de modulation de façon telle que leur modulation s'opère respectivement en synchronisme.

6. Dispositif selon l'une des revendications 1 à 5, **caractérisé en ce que** plusieurs connexions de modulation (m1, m2, m3) sont disposées à des intervalles sensiblement égaux le long de la longueur des bandes et sont reliées aux photogrilles de modulation (1, 2).

7. Dispositif selon l'une des revendications 1 à 6, **caractérisé en ce que** les photogrilles de modulation directement adjacentes aux grilles d'accumulation (4, 5) reçoivent partiellement, sur le côté orienté vers les grilles d'accumulation, un recouvrement au moyen d'une bande de contact de conductivité élevée et de transparence nulle ou très faible vis à vis des ondes électromagnétiques.

8. Dispositif selon l'une des revendications 1 à 7, **caractérisé en ce que** le dispositif présente un ou plusieurs éléments pixels, un élément pixel étant constitué de plusieurs paires de grilles de modulation (1, 2) et de grilles d'accumulation (4, 5), les directions de bandes d'éléments pixels adjacents sous différentes tensions de modulation étant, de préférence, perpendiculaires les unes aux autres et, transversalement à la direction des bandes, les extrémités du pixel étant définies chacune par au moins une photogrille de modulation (1, 2) qui se raccorde à une grille d'accumulation (4, 5) intérieure la plus proche.

9. Dispositif selon la revendication 8, **caractérisé en ce que** les connexions de grilles d'accumulation sont prévues respectivement sur une face avant des bandes d'un pixel, une grille d'accumulation sur deux étant reliée respectivement à l'une de deux lignes de lecture et les autres grilles d'accumulation étant reliées respectivement à l'autre des lignes de connexion, les lignes de lecture conduisant à un circuit d'évaluation.

10. Dispositif selon la revendication 8 ou 9, **caractérisé en ce que** deux éléments pixels (10, 10') sont disposés avec leurs bandes de manière parallèle et directement côte à côte de sorte que les photogrilles de modulation directement adjacentes les unes aux autres, lesquelles définissent les extrémités ou côtés juxtaposés des deux éléments pixels (10, 10'), forment une paire de photogrilles de modulation (1, 2) modulable au choix symétriquement ou en décalage de phase, formant ainsi soit un élément pixel unique de double dimension, soit permettant deux mesures indépendantes, par exemple d'un signal en phase et d'un signal en quadrature, avec les deux éléments pixels.

11. Dispositif selon l'une des revendications 8 ou 9, **caractérisé en ce que** quatre éléments pixels sont disposés dans un rectangle, les bandes des pixels diagonalement opposés dans le rectangle s'étendant chacune de manière parallèle entre elles, tandis que les bandes des éléments pixels directement adjacents s'étendent perpendiculairement les unes aux autres, et les connexions de modulation étant connectées de sorte que la modulation d'éléments pixels (10) adjacents puisse s'effectuer en décalage de phase, et ce de préférence respectivement de 90°.

12. Dispositif selon la revendication 9, **caractérisé en ce que** chacun des éléments pixels (10) a une forme sensiblement carrée et les quatre éléments pixels sont assemblés pour former un carré, ou **en ce que** les angles sont, en outre, découpés de façon à obtenir une forme sensiblement octaèdre.

13. Dispositif selon la revendication 12, **caractérisé en ce que** les quatre éléments pixels sont regroupés en diagonale, au choix, individuellement ou par deux, ou sont regroupés par quatre, et **en ce que**, dans le cas du fonctionnement à 4 quadrants et du fonctionnement à 2 quadrants, on évalue en outre le gradient ou le vecteur normal de l'élément de surface.

14. Dispositif selon l'une des revendications 1 à 12, **caractérisé en ce que** les photogrilles de modulation et les grilles d'accumulation et la périphérie d'évaluation de signaux et périphérie de modulation correspondantes sont réalisées en partie "on-chip" et en partie sous forme de module multi-puces dans la technologie CMOS ou la technologie BICMOS.

15. Dispositif selon l'une des revendications 1 à 14, **caractérisé en ce que** sont disposées au-dessus des photogrilles de modulation (1, 2) des lentilles en barreau qui focalisent exclusivement sur les photogrilles de modulation (1, 2) la lumière atteignant sensiblement la totalité de la surface d'un élément pixel.

16. Dispositif selon l'une des revendications 1 à 15, **caractérisé en ce que** plusieurs pixels sont disposés dans un réseau en forme de lignes ou un réseau matriciel.

17. Dispositif selon l'une des revendications 1 à 16, **caractérisé en ce que** dans un réseau en forme de lignes ou un réseau matriciel sont utilisés de manière mixte aussi bien des pixels de photodétecteur mixte à fonctionnalité 3D que des pixels CMOS conventionnels à fonctionnalité 2D, les différentes informations de pixels, en particulier adjacentes, étant acheminées à un dispositif de fusion de données et d'interpolation pour la reconstruction de l'image en profondeur.

18. Dispositif selon la revendication 16 et 17, **caractérisé en ce qu'**est associée de préférence à chaque pixel de PMD une microlentille qui concentre la lumière incidente sur le réseau sensiblement sur la surface photosensible des différents pixels.

19. Dispositif selon l'une des revendications 1 à 18, **caractérisé en ce qu'**il est prévu pour détecter des ondes électromagnétiques dans le domaine optique, dans le domaine infrarouge proche ou dans le domaine ultraviolet.

20. Dispositif selon l'une des revendications 1 à 19, **caractérisé en ce que** les grilles d'accumulation sont réalisées sous forme de diodes de lecture avec la cathode comme électrode de lecture.

21. Utilisation d'un dispositif selon l'une des revendications 1 à 20, **caractérisée en ce que** le dispositif est utilisé comme élément de prise de vues photosensible dans une caméra.

22. Application du dispositif selon l'une des revendications 1 à 20, **caractérisé en ce que** le dispositif s'utilise dans le traitement optique des signaux en tant qu'élément de mélange ou de corrélation sensible à la fréquence et à la phase pour l'acquisition des signaux, le traitement des signaux et la suppression du bruit.

23. Procédé pour faire fonctionner un dispositif selon l'une des revendications 1 à 20, **caractérisé en ce qu'**une scène à reproduire est éclairée par une lumière modulée selon une fonction de modulation, où les photogrilles de modulation (1, 2) sont modulées au moyen de la même fonction de modulation, toutefois alors bipolaire ou symétrique et où, au choix pour une moitié d'un pixel à 2 quadrants ou à 4 quadrants, on obtient également une modulation déphasée de 90° en cas de modulation sinusoïdale ou une largeur de bit en cas d'onde carrée ou une largeur de puce en cas de modulation PN des tensions de photogrilles de modulation.

24. Utilisation d'un dispositif selon l'une des revendications 1 à 20, **caractérisée en ce que** le dispositif s'utilise dans un circuit optique PLL ou DLL qui est, de préférence, un circuit intégré à haute densité d'intégration et qui est utilisé, de préférence, dans des barrières lumineuses, sous forme de réseau PLL dans des caméras temps de vol, dans des télécommandes optiques et dans des cellules photoélectriques de données ainsi que pour la régénération de signaux de données dans la transmission optique d'informations avec différents modes de modulation.

25. Utilisation d'un dispositif selon l'une des revendications 1 à 20 et 24, **caractérisée en ce que** le dispositif s'utilise dans un circuit optique PLL ou DLL avec un DLL de photodétecteur mixte à 2 quadrants sur la base d'un récepteur de photodétecteur mixte IQ, en particulier avec modulation PN, des signaux de données numériques codés PN étant utilisés pour la sélection de canaux multiples, la détection de cibles multiples et pour une sensibilité extrême dans la résolution du retard de phase, la tension de sortie différentielle étant formée en tant que différence des écarts des courants photoélectriques, exprimée en U_{Δ} = const (|iₐ - i_{b}| - |i_{c} - i_{d}|) et réacheminée, via un filtre à boucle ou un régulateur numérique, en tant que variable de réglage du multivibrateur commandé en tension à la fréquence de puce, et le signal de données du flux de données 1/0 codées PN étant régénéré à l'aide du cycle de mot récupéré en formant dans l'amplificateur sommateur (41) la somme des différences des courants photoélectriques U'_{Σ} = const (|iₐ - i_{b}| - |i_{c} - iₐ|) respectivement via une longueur de mot PN à l'aide d'un intégrateur à court terme contenu dans l'amplificateur sommateur.
